# EUROPÄISCHE PATENTANMELDUNG

(11) **EP 1 764 826 A1**
(43) Veröffentlichungstag der Anmeldung: **21.03.2007**
(21) Anmeldenummer: 06120185.1
(22) Anmeldetag: 06.09.2006
(51) Int. Cl.: H01L 21/00, H05K 13/04, B65B 15/04, H05K 13/08, H05K 13/02, G06T 3/40

(54) **Vorrichtung zur Positionsvermessung von elektronischen Bauelementen**

(30) Priorität: 20.09.2005 DE 102005044866
(71) Anmelder: SIEMENS AKTIENGESELLSCHAFT, 80333 München (DE)
(72) Erfinder: Stanzl, Harald, 81476 München (DE)

(57) **Zusammenfassung**

Die Erfindung schafft eine Vorrichtung zur Positionsvermessung von elektronischen Bauelementen (122), insbesondere von ungehäusten Bauelementen, welche von einer Waferaufnahme (120) an einer klebrigen Trägerfolie (121) gehalten werden, zum Zwecke einer präzisen Abholung der Bauelemente (122) durch einen Bestückkopf (160). Die erfindungsgemäße Vorrichtung umfasst eine Handhabungsvorrichtung (105) für die Waferaufnahme (120) und eine an einem Chassis (110) der Handhabungsvorrichtung (105) ortsfest angebrachte Kamera (130), welche derart angeordnet ist, dass die Bauelemente (122) unter einem schrägen Beobachtungswinkel erfassbar sind. Die Handhabungsvorrichtung (105) weist bevorzugt eine Verschiebevorrichtung (111) auf, welche zum Positionieren der Waferaufnahme (120) relativ zu dem Chassis (110) eingerichtet ist. Die Kamera (130) ist bevorzugt derart angeordnet, dass lediglich Bauelemente (122) erfassbar sind, welche sich innerhalb eines Erfassungsbereiches um eine relativ zum Chassis (110) ortsfeste Abholposition befinden. Zur Verbesserung der Abbildungseigenschaften kann die Kamera (130) mit einer telezentrischen Optik (131) ausgestattet sein.

## Beschreibung

Die Erfindung betrifft eine Vorrichtung zur Positionsvermessung von elektronischen Bauelementen, insbesondere von ungehäusten Bauelementen, welche von einer Waferaufnahme an einer Trägerfolie gehalten werden. Die genaue Positionsvermessung erfolgt bevorzugt zum Zwecke einer präzisen Abholung der Bauelemente durch einen Bestückkopf einer Bestückvorrichtung, welche zum automatischen Bestücken von Bauelementen auf Bauelementeträger, insbesondere Leiterplatten, vorgesehen ist.

Aufgrund der zunehmenden Miniaturisierung von elektronischen Bauelementen wird es bereits in naher Zukunft nicht mehr wirtschaftlich sein, elektronische Bauelemente, welche auf ein elektronisches Schaltungssubstrat bestückt werden sollen, zum Zwecke einer sicheren Bauelement-Zuführung für einen Bestückprozess umzupacken. Ein derartiges Umpacken in spezielle Bauelement-Zuführgurte ist heutzutage üblich, um die Bauelemente einzeln dem Bestückprozess zuzuführen. Vielmehr wird von modernen Bestücksystemen verlangt, dass sie die Bauelemente unmittelbar von einem Wafer entnehmen und auf entsprechende Stellen eines elektronischen Schaltungssubstrats aufsetzen.

Um die Handhabung von ungehäusten elektronischen Bauelemente (sog. Bare Dies) zu vereinfachen, wird der gesamte Wafer vor einer Bauelement-Vereinzelung auf einer klebrigen Trägerfolie aufgebracht. Die Vereinzelung erfolgt üblicherweise durch einen hochpräzisen mechanischen Säge- oder durch einen hochpräzisen chemischen Ätzvorgang.

Von der Trägerfolie werden die Bauelemente von einem Sauggreifer entnommen und einem Bestückprozess zugeführt. Ein Ablösen der Bauelemente von der klebrigen Trägerfolie wird in bekannter Weise durch sog. Ausstoßnadeln unterstützt, welche beispielsweise aus der EP 565781 A1 bekannt sind.

Für einen zuverlässigen Bestückprozess ist es erforderlich, dass die Bauelemente möglichst mittig von dem Sauggreifer aufgenommen werden, damit während des Ablöseprozesses keine Drehmomente wirken, welche eine sichere Bauelement-Aufnahme gefährden. Aus diesem Grund müssen die Positionen der aufzunehmenden Bauelemente genau bestimmt werden.

Aus der JP 07-221164 A ist eine Entnahmevorrichtung für von einer Waferaufnahme gehaltene Bare Dies bekannt, bei der vor einer Bauteilaufnahme die gesamte Struktur der Waferaufnahme vermessen wird. Die Entnahmevorrichtung hat den Nachteil, dass eventuell nach der Vermessung auftretende Positionsverschiebungen einzelner Bauelemente nicht erkannt werden und dementsprechend die Prozesssicherheit bei der Bauteilaufnahme reduziert ist.

Aus der JP 11-150132 A ist eine Entnahmevorrichtung für von einer Waferaufnahme gehaltene ungehäuste Bauelemente bekannt, welche Bauelemente einem Die-Bonding Prozess zugeführt werden. Vor der Entnahme der Bauelemente wird die Waferaufnahme von einer Kamera vermessen und in eine für die Entnahme der Bauelemente mittels einer Saugpipette geeignete Position gebracht. Die Entnahmevorrichtung hat ebenfalls den Nachteil, dass eventuell nach der Vermessung auftretende Positionsverschiebungen einzelner Bauelemente nicht erkannt werden.

Aus der JP 02-137338 A ist ein Positionsdetektor für ungehäuste Bauelemente bekannt. Der Positionsdetektor umfasst eine Kamera, welche oberhalb des Bauelements positioniert werden kann. Durch eine Bildauswertung der Außenkanten des Bauelements kann die genaue räumliche Lage des Bauelements bestimmt und somit die Genauigkeit eines Die Bonding Prozesses verbessert werden. Die senkrechte Erfassung des Bauelements hat den Nachteil, dass in Falle einer Aufnahme des Bauelement durch eine Haltevorrichtung eines Bestückkopfes die Bewegungsfreiheit des Bestückkopfes stark eingeschränkt ist.

Aus der US 5,541,834 ist ein Vision-System zum Erfassen eines von einer Haltevorrichtung eines Bestückkopfes aufgenommen Bauelements bekannt. Das Vision-System, welches eine Kamera und eine Beleuchtungseinheit umfasst und welches seitlich an dem Bestückkopf angebracht ist, ermöglicht gleichzeitig mit der Erfassung des Bauelements eine Vermessung von auf einem Bauelementeträger ausgebildeten Anschlussflächen. Auf diese Weise kann das Bauelement mit hoher Genauigkeit bestückt werden. Das Vision-System hat den Nachteil, dass lediglich die Position eines von dem Bestückkopf aufgenommenen Bauelements und nicht die Position eines noch aufzunehmenden Bauelements vermessen werden kann. Die Präzision der Bauelement-Aufnahme kann durch das Vision-System nicht erhöht werden.

Der Erfindung liegt die Aufgabe zugrunde, eine Vorrichtung zur Positionsvermessung von elektronischen Bauelementen zu schaffen, welche zum einen eine präzise Bauelement-Aufnahme durch einen Bestückkopf und zum anderen eine große Bewegungsfreiheit des Bestückkopfes ermöglicht.

Diese Aufgabe wird gelöst durch eine Vorrichtung zur Positionsvermessung von elektronischen Bauelementen, insbesondere von ungehäusten, von einer Waferaufnahme an einer klebrigen Trägerfolie gehalten Bauelementen, mit den Merkmalen des unabhängigen Anspruchs 1. Die erfindungsgemäße Vorrichtung zur Positionsvermessung umfasst eine Handhabungsvorrichtung für die Waferaufnahme und eine an einem Chassis der Handhabungsvorrichtung ortsfest angebrachte Kamera. Die Kamera ist derart angeordnet, dass die Bauelemente unter einem schrägen Beobachtungswinkel erfassbar sind.

Der Erfindung liegt die Erkenntnis zugrunde, dass eine präzise Lagevermessung der Bauelemente auch unter einem schrägen Beobachtungswinkel möglich ist, so dass die Bauhöhe der erfindungsgemäßen Vorrichtung im Vergleich zu einer senkrechten Erfassung der Bauelemente deutlich reduziert werden kann. Auf diese Weise kann eine kompakte Zuführvorrichtung für Bauelemente, welche von einer Waferaufnahme einer klebrigen Trägerfolie gehalten werden, realisiert werden. Eine kompakte Zuführvorrichtung hat den Vorteil, dass der die Bauelemente abholende Bestückkopf innerhalb eines großen Bewegungsbereichs positioniert werden kann, ohne dass Kollisionen zwischen dem Bestückkopf und der ortsfest angebrachten Kamera zu befürchten sind.

Die Waferaufnahme ist üblicherweise ein steifer Rahmen, in dem die Trägerfolie gespannt ist. Die auf der Trägerfolie befindlichen Bauelemente sind bevorzugt so genannte ungehäuste Bauelemente (Bare Dies), Flip-Chips oder sonstige Surface-Mount-Device-Bauelemente (SMD-Bauelemente), welche in herkömmlicher Weise mittels eines Bestückautomaten auf vorgesehene Positionen eines Bauelementeträgers transferiert werden können.

Gemäß Anspruch 2 weist die Handhabungsvorrichtung eine Verschiebevorrichtung auf, welche zum Positionieren der Waferaufnahme relativ zu dem Chassis eingerichtet ist. Dies hat den Vorteil, dass die Bauelement-Aufnahme immer an derselben Stelle relativ zum Chassis erfolgen kann. Auf diese Weise kann die Position jedes Bauelementes unmittelbar vor dem Abholvorgang vermessen werden, so dass ein Verzug der üblicherweise elastischen Trägerfolie und die damit verbundene Positionsverschiebung einzelner Bauelemente unmittelbar vor dem Abholvorgang erfasst werden kann.

Ein Verzug der Trägerfolie tritt üblicherweise dadurch auf, dass innerhalb eines bestimmten Bereichs der Waferaufnahme sämtliche oder nahezu sämtliche elektronischen Bauelemente abgeholt werden. Da die Elastizität der von Bauelementen entleerten Trägerfolie in der Regel größer ist als die Elastizität der mit Bauelementen versehenen Trägerfolie (Bauelemente sind üblicherweise starre Gebilde), führt eine über die gesamte Fläche der Waferaufnahme ungleichmäßige Bauelement-Entnahme häufig zu einem Verzug der Trägerfolie. Sofern jedoch die Positionsverschiebung eines abzuholenden Bauelements bekannt ist, kann durch eine entsprechende Ansteuerung der Verschiebvorrichtung diese Positionsverschiebung kompensiert werden, so dass stets eine mittige Aufnahme der Bauelemente durch eine Haltevorrichtung, typischerweise ein Sauggreifer, gewährleistet ist.

Gemäß Anspruch 3 ist die Kamera derart angeordnet, dass lediglich Bauelemente erfassbar sind, welche sich innerhalb eines vorgegebenen Erfassungsbereiches um eine relativ zum Chassis ortsfeste Abholposition befinden. Dies hat den Vorteil, dass für die Kamera kein eigenes Positioniersystem erforderlich ist, so dass die Justierung der Kamera bereits bei der Herstellung der Zuführvorrichtung vorgenommen werden kann. Die optische Justierung der Kamera ist dann besonders stabil, so dass Nachjustierungen nicht erforderlich sind.

Gemäß Anspruch 4 ist die Kamera mit einer telezentrischen Optik ausgestattet. Dies hat den Vorteil, dass Abbildungsfehler, welche durch den schrägen Beobachtungswinkel der Kamera hervorgerufen werden, deutlich reduziert werden. Derartige Abbildungsfehler, welche bei Verwendung einer konventionellen Optik besonders stark hervortreten, werden durch eine Verzerrung des Bildes infolge von Abbildungsfehlern verursacht, wie beispielsweise ein Kissenverzug und/oder auch durch unterschiedliche Abstände unterschiedlicher Objektpunkte. Die Bildverzerrung infolge der unterschiedlichen Abstände einzelner Objektpunkte wird durch die telezentrische Anordnung des Strahlengangs nahezu vollständig behoben. Auf diese Weise trägt die telezentrische Optik maßgeblich zu einer weitgehend unverzerrten Abbildung bei, so dass die Position eines aufzunehmenden Bauelements besonders genau bestimmt werden kann.

Ein telezentrischer Strahlengang hat zudem den Vorteil, dass die Intensität von unerwünschtem Fremdlicht, welches in die Kamera eindringt, erheblich reduziert ist. Dies trägt ebenfalls zu einer genauen Bilderkennung und damit insgesamt zu einer hohen Prozessstabilität bei.

Gemäß Anspruch 5 umfasst die Vorrichtung zur Positionsvermessung von elektronischen Bauelementen zusätzlich einen ersten Reflektor, welcher in dem Strahlengang der Kamera angeordnet ist. Dies hat den Vorteil, dass durch eine in Bezug auf die Abholebene der Bauelemente besonders niedrige Anordnung der Kamera insgesamt eine besonders flache Bauweise der Zuführvorrichtung realisiert werden kann, so dass der Bewegungsbereich des Bestückkopfes, in dem eine räumliche Kollision mit der Kamera ausgeschlossen ist, besonders groß ist. Zur weiteren Verbesserung der Kollisionsfreiheit kann der Reflektor auch beweglich gelagert sein, so dass er nach einem Abholen eines Bauelements in eine Position gebracht wird, in der er die Bewegungsfreiheit des Bestückkopfes möglichst wenig einschränkt. Insbesondere kann der erste Reflektor durch einen einfachen Klappmechanismus aus dem Bewegungsbereich des Bestückkopfes entfernt werden.

Gemäß Anspruch 6 weist die Vorrichtung zur Positionsvermessung von elektronischen Bauelementen zusätzlich eine an dem Chassis der Handhabungsvorrichtung ortsfest angebrachte Beleuchtungseinheit auf. Die Beleuchtungseinheit ist derart angeordnet, dass die Bauelemente unter einem schrägen Winkel beleuchtbar sind. Die schräge Beleuchtung hat ebenso wie die schräge Erfassung den Vorteil, dass die Zuführeinheit innerhalb einer niedrigen Bauhöhe aufgebaut werden kann und somit eine besonders große Bewegungsfreiheit des Bestückkopfes erreicht werden kann.

Gemäß Anspruch 7 werden die Bauelemente mit einer Hellfeldbeleuchtung erfasst. Dies bedeutet, dass der Winkel, unter dem die abzuholenden Bauelemente beleuchtet werden, relativ zu der durch die flächige Trägerfolie vorgegebenen Abholebene gleich groß wie der Winkel ist, unter dem die Bauelemente beobachtet bzw. erfasst werden. Ferner liegen die Strahlengänge des Beleuchtungslichts und des Mess- bzw. Erfassungslichts in einer Ebene senkrecht zu der Abholebene. Die Hellfeldbeleuchtung hat den Vorteil, dass insbesondere stark spiegelnde Bauelemente anhand ihrer Kanten besonders genau erkannt werden können. Die Lageerkennung kann somit besonders genau durchgeführt werden, so dass die Prozesssicherheit bei der Abholung der Bauelemente besonders hoch ist.

Gemäß Anspruch 8 ist ein zweiter Reflektor vorgesehen, welcher im Strahlengang der Beleuchtungseinheit angeordnet ist. Der zweite Reflektor trägt ebenso wie der erste Reflektor dazu bei, dass die Zuführvorrichtung innerhalb einer kompakten Bauweise mit der damit verbundenen großen Bewegungsfreiheit des Bestückkopfes realisiert werden kann.

Gemäß Anspruch 9 ist der zweite Reflektor schwenkbar gelagert, so dass durch ein Einklappen des Reflektors eine zusätzliche Erhöhung der Bewegungsfreiheit des Bestückkopfes erreicht werden kann.

Gemäß Anspruch 10 weist die Vorrichtung zur Positionsvermessung zusätzlich eine der Kamera nachgeschaltete Auswerteeinheit zur Lageerkennung der an der Abholposition befindlichen Bauelemente auf. Dies hat den Vorteil, dass die gesamte Lagevermessung der abzuholenden Bauelemente innerhalb einer als autarkes Modul ausgebildeten Zuführeinrichtung realisiert werden kann. Ferner kann durch eine so genannte Online-Überwachung der Abholung und durch eine entsprechende Ansteuerung der Positionierung des Bestückkopfes die Abholsicherheit weiter erhöht werden.

Gemäß Anspruch 11 ist die Auswerteeinheit derart eingerichtet, dass eine Verzerrung eines von der Kamera aufgenommenen Bildes kompensierbar ist. Dazu ist zunächst eine Bestimmung der Verzerrung erforderlich. Dies kann dadurch erfolgen, dass Kalibriermarken, die sich innerhalb des Erfassungsbereichs der Kamera befinden, hinsichtlich ihrer Position und/oder hinsichtlich ihrer Form genau vermessen werden. Eine Kompensation der Verzerrung erfolgt dann in bekannter Weise durch übliche Methoden der Bildverarbeitung.

Weitere Vorteile und Merkmale der vorliegenden Erfindung ergeben sich aus der folgenden beispielhaften Beschreibung derzeit bevorzugter Ausführungsformen.

In der Zeichnung zeigen in schematischen Darstellungen
- Figur 1: eine Wafer-Zuführvorrichtung mit einer Einrichtung zur Positionsvermessung von elektronischen Bauelementen gemäß einem ersten Ausführungsbeispiel der Erfindung und
- Figur 2: eine Wafer-Zuführvorrichtung mit einer Einrichtung zur Positionsvermessung von elektronischen Bauelementen gemäß einem zweiten Ausführungsbeispiel der Erfindung, bei dem die Bauelemente über einen Reflektor von einer flach angeordneten Kamera erfassbar sind.

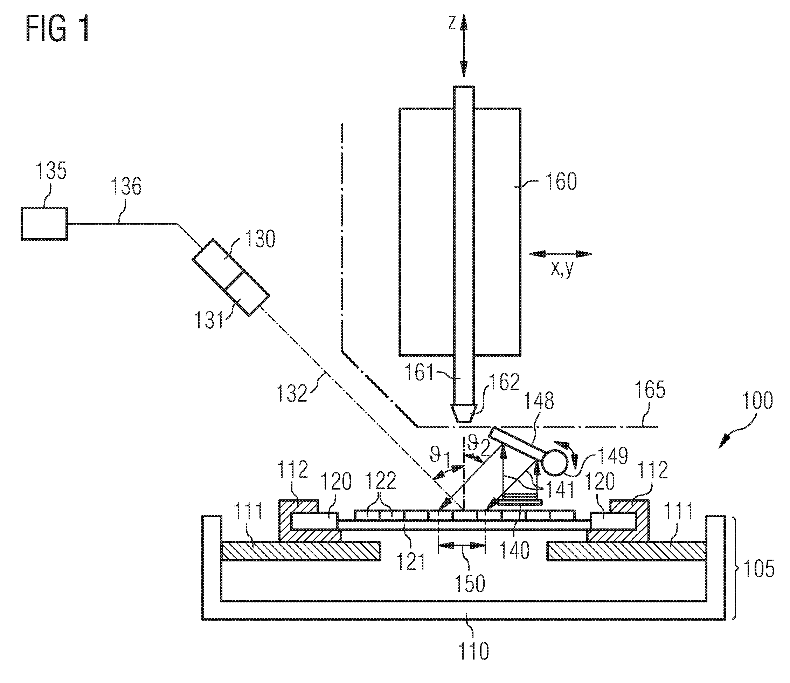

Die in Figur 1 dargestellte Wafer-Zuführvorrichtung 100 umfasst eine Wafer-Handhabungsvorrichtung 105. Die Wafer-Handhabungsvorrichtung 105 umfasst ein Chassis 110, an welchem eine Verschiebevorrichtung 111 angebracht ist. Die Verschiebevorrichtung 111 ist derart ausgebildet, dass zumindest zwei Klemmhalterungen 112 horizontal, d.h. in einer x-y-Ebene positioniert werden können.

Die Klemmhalterungen 112 sind zur Aufnahme einer Waferaufnahme vorgesehen, welche einen Halterahmen 120 und eine in dem Halterahmen 120 aufgespannte Trägerfolie 121 aufweist. Die Trägerfolie 121 zeichnet sich durch eine klebrige Oberseite aus, an der eine Vielzahl von vereinzelten Bauelementen 122 infolge der von der Trägerfolie 121 vermittelten Klebekraft fixiert sind.

Die Wafer-Zuführvorrichtung 100 umfasst ferner nicht dargestellte Hilfsmittel, wie beispielsweise Ausstoßnadeln, welche an der Unterseite der Trägerfolie 121 angreifen und in bekannter Weise ein Abholen eines Bauelements 122 durch einen Bestückkopf 160 unterstützen. Zum Aufnehmen eines Bauelements 122 ist der Bestückkopf 160 mit einem hohlen Schaft 161 versehen, welcher relativ zu dem Bestückkopf entlang einer z-Richtung verschiebbar ist. An der Unterseite des hohlen Schafts 161 befindet sich eine Saugpipette 162, welche einen durch eine nicht dargestellte Vakuumerzeugungseinheit generierten Unterdruck an die Oberseite eines zu entnehmenden Bauelements 122 überträgt. Zum Abholen des Bauelements 122 wird der hohle Schaft 161 nach unten bewegt, so dass die Saugpipette 162 mit der Oberfläche des zu entnehmenden Bauelements in Kontakt kommt. Sofern nun die durch den Unterdruck vermittelte Ansaugkraft größer ist als die durch die klebrige Trägerfolie 121 vermittelte Haftkraft, kann das betreffende Bauelement 122 durch Anheben des hohlen Schafts 161 von der Waferaufnahme entnommen werden. Selbstverständlich dient die nicht dargestellte Ausstoßeinrichtung dazu, durch eine punktuelle Wölbung der Trägerfolie 121 die Klebefläche zwischen dem zu entnehmenden Bauelement 122 und der Trägerfolie 121 zu reduzieren, so dass die Klebkraft zwischen Bauelement 122 und Trägerfolie 121 erheblich reduziert ist.

Die Aufnahme eines Bauelements 122 durch den Bestückkopf 160 erfolgt in der Weise, dass durch eine geeignete Positionierung der Waferaufnahme relativ zu dem Chassis 110 jeweils das zu entnehmende Bauelement 122 in einem Erfassungsbereich 150 bewegt wird, von dem es durch den Bestückkopf 160 aufgenommen werden kann.

Eine sichere Bauelement-Aufnahme kann insbesondere in Anbetracht der kleinen Bauform von miniaturisierten Bauelementen nur dadurch erreicht werden, dass die Lage des jeweils aufzunehmenden Bauelements vorab erfasst wird. Dazu ist eine Kamera 130 vorgesehen, welche an dem Chassis 110 über eine nicht dargestellte Halterung ortsfest angebracht ist. Die Kamera ist dabei relativ zu dem Erfassungsbereich 150 derart angeordnet, dass diejenigen Bauelemente 122, welche sich innerhalb des Erfassungsbereichs 150 befinden, entlang einer optischen Achse 132 unter einem Winkel ϑ₁ erfasst werden. Der Winkel ϑ₁ ist dabei der Winkel, der durch die optische Achse 132 und durch die Flächennormale der klebrigen Trägerfolie 121 bestimmt ist. Um trotz des schrägen Erfassungswinkels eine möglichst geringe Bildverzerrung zu erreichen, ist die Kamera 130 mit einer telezentrischen Optik 131 ausgestattet. Dadurch wird sichergestellt, dass der Abbildungsmaßstab der Optik 131 unabhängig von der exakten Entfernung von unterschiedlichen Kanten des Bauelements 122 stets konstant ist. Die Bauelemente 122 können somit über eine Auswerteeinheit 135, welche über eine Signalleitung 136 mit der Kamera 130 verbunden ist, zuverlässig erkannt werden. Die Lageerkennung der aufzunehmenden Bauelemente 122, die sich innerhalb des Erfassungsbereichs 150 befinden, erfolgt bevorzugt anhand der Kanten des jeweiligen Bauelements 122 oder anhand von auf der Oberfläche des Bauelements 122 vorhandenen Strukturen.

Um stets eine genaue Lageerkennung der aufgenommenen Bauelemente zu gewährleisten, weist die Wafer-Zuführvorrichtung 100 ferner eine Beleuchtungseinheit 140 auf, welche ebenfalls an dem Chassis 110 durch eine nicht dargestellte Halterung ortsfest angeordnet ist. Um eine flache Bauhöhe der gesamten Wafer-Zuführvorrichtung 100 zu ermöglichen, befindet sich die Beleuchtungseinheit 140 unmittelbar oberhalb der durch die Trägerfolie 121 bestimmten Abholebene. Die Beleuchtungseinrichtung 140 emittiert ein Beleuchtungslicht, wobei die entsprechenden Beleuchtungsstrahlen 141 an einem Reflektor 148 reflektiert auf den Erfassungsbereich 150 auftreffen. Die an dem Reflektor 148 reflektierten Beleuchtungsstrahlen 141 treffen unter einem Winkel ϑ₂ relativ zu der Flächennormalen der Trägerfolie 121 in dem Erfassungsbereich 150 auf.

Die Beleuchtung der in dem Erfassungsbereich 150 befindlichen Bauelemente über den Reflektor 148 hat den Vorteil, dass die Bauhöhe der Wafer-Zuführvorrichtung 100 klein gehalten werden kann und somit der Bestückkopf 160 innerhalb eines großen Bereichs beliebig verfahren werden kann, ohne dass eine Kollision zwischen dem Bestückkopf 160 und dem Reflektor 148 zu befürchten ist. Ein weiterer Vorteil der kompakten Anordnung der Beleuchtungseinheit 140 besteht darin, dass infolge des vergleichsweise kurzen optischen Weges zwischen der Beleuchtungseinheit 140 und dem Erfassungsbereich 150 die in dem Erfassungsbereich 150 befindlichen Bauelemente mit einer hohen Lichtintensität beleuchtet werden.

Um die Bewegungsfreiheit des Bestückkopfes 160 weiter zu erhöhen, ist ferner ein Klappmechanismus 149 vorgesehen, welcher eine Schwenkbewegung des Reflektors 148 ermöglicht. Auf diese Weise kann unmittelbar nach der Aufnahme eines Bauelements durch die Saugpipette 142 der Reflektor 148 im Uhrzeigersinn geschwenkt werden, so dass der Bestückkopf 160 innerhalb einer x-y-Ebene kollisionsfrei bewegt werden kann. Die entsprechende untere Störkante für den Bewegungsbereich des Bestückkopfes 160 ist durch eine gestrichelte Linie dargestellt, die mit dem Bezugszeichen 165 versehen ist.

Gemäß dem hier dargestellten Ausführungsbeispiel sind die Winkel ϑ₁ und ϑ₂ gleich groß, so dass die in dem Erfassungsbereich 150 befindlichen Bauelemente von einer Hellfeldbeleuchtung beleuchtet werden. Diese Art der Beleuchtung ist insbesondere bei stark spiegelnden Bauelementen vorteilhaft, da unter einer Hellfeldbeleuchtung die Kanten der Bauelemente sehr zuverlässig erkannt und damit die Bauelementposition zuverlässig ermittelt werden kann. Eine zuverlässige Positionserkennung der aufzunehmenden Bauelemente erhöht wiederum die Prozessstabilität der Bauelementaufnahme, da bei einer gegebenenfalls vorhandenen Positionsverschiebung der Bauelemente durch eine geeignete Ansteuerung der Verschiebevorrichtung 111 diese Positionsverschiebung in geeigneter Weise kompensiert werden kann. Auf diese Weise ist sichergestellt, dass die Bauelemente stets mittig von der Saugpipette 162 aufgenommen werden.

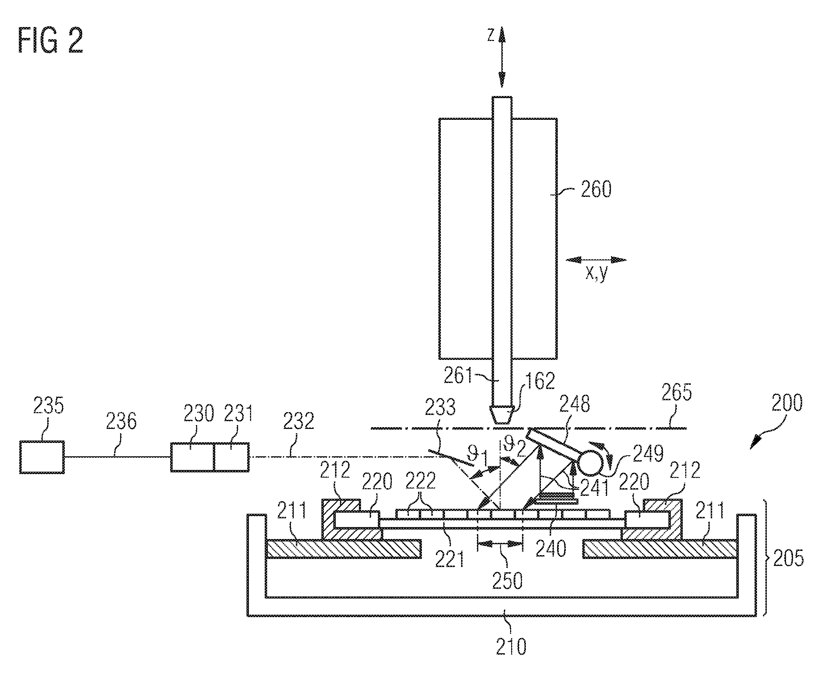

Figur 2 zeigt als weitere Ausführungsform eine Wafer-Zuführvorrichtung 200, welche sich von der in Figur 1 dargestellten Wafer-Zuführvorrichtung 100 lediglich dadurch unterscheidet, dass die Erfassung der in dem Erfassungsbereich 250 befindlichen Bauelemente 222 über einen Reflektor 233 erfolgt, welcher in dem Strahlengang zwischen der Kamera 230 und dem Erfassungsbereich 250 angeordnet ist. Die Umlenkung des Strahlengangs zwischen Erfassungsbereich 250 und Kamera 230 hat den Vorteil, dass die Wafer-Zuführvorrichtung 200 in einer besonders kompakten, d.h. niedrigen Bauform realisiert werden kann, so dass der zuverlässig kollisionsfreie Bewegungsbereich des Bestückkopfes 260 entsprechend erweitert ist. Die entsprechende Störkante für den Bewegungsbereich des Bestückkopfes 260 ist ebenfalls durch eine gestrichelte Linie dargestellt, welche mit dem Bezugszeichen 265 versehen ist.

Die übrigen Komponenten der Wafer-Zuführvorrichtung 200 entsprechen den Komponenten der Wafer-Zuführvorrichtung 100, die bereits zuvor anhand von Figur 1 erläutert wurde. Um unnötige Wiederholungen zu vermeiden, werden diese Komponenten, welche jeweils mit Bezugszeichen versehen sind, die sich gegenüber dem Bezugszeichen der entsprechenden Komponenten der Wafer-Zuführvorrichtung 100 lediglich in ihrer ersten Ziffer unterscheiden, nicht mehr im Detail erläutert.

### Bezugszeichenliste

- 100: Wafer-Zuführvorrichtung
- 105: Wafer-Handhabungsvorrichtung
- 110: Chassis
- 111: Verschiebevorrichtung
- 112: Klemmhalterung
- 120: Halterahmen
- 121: klebrige Trägerfolie
- 122: vereinzeltes Bauelement
- 130: Kamera
- 131: telezentrische Optik
- 132: optische Achse (Erfassung)
- 135: Auswerteeinheit
- 136: Signalleitung
- 140: Beleuchtungseinheit
- 141: Beleuchtungsstrahlen
- 148: Reflektor
- 149: Klappmechanismus
- 150: Erfassungsbereich
- 160: Bestückkopf
- 161: hohler Schaft
- 162: Saugpipette
- 165: Störkante für Bewegungsbereich
- ϑ₁: Erfassungswinkel
- ϑ₂: Beleuchtungswinkel

- 200: Wafer-Zuführvorrichtung
- 205: Wafer-Handhabungsvorrichtung
- 210: Chassis
- 211: Verschiebevorrichtung
- 212: Klemmhalterung
- 220: Halterahmen
- 221: klebrige Trägerfolie
- 222: vereinzeltes Bauelement
- 230: Kamera
- 231: telezentrische Optik
- 232: optische Achse (Erfassung)
- 233: Reflektor
- 235: Auswerteeinheit
- 236: Signalleitung
- 240: Beleuchtungseinheit
- 241: Beleuchtungsstrahlen
- 248: Reflektor
- 249: Klappmechanismus
- 250: Erfassungsbereich
- 260: Bestückkopf
- 261: hohler Schaft
- 262: Saugpipette
- 265: Störkante für Bewegungsbereich
- ϑ₁: Erfassungswinkel
- ϑ₂: Beleuchtungswinkel

## Patentansprüche

1. Vorrichtung zur Positionsvermessung von elektronischen Bauelementen (122), insbesondere von ungehäusten Bauelementen, welche von einer Waferaufnahme (120) an einer klebrigen Trägerfolie (121) gehalten werden, zum Zwecke einer präzisen Abholung der Bauelemente (122) durch einen Bestückkopf (160), mit
• einer Handhabungsvorrichtung (105) für die Waferaufnahme (120) und
• einer an einem Chassis (110) der Handhabungsvorrichtung (105) ortsfest angebrachten Kamera (130), welche derart angeordnet ist, dass die Bauelemente (122) unter einem schrägen Beobachtungswinkel erfassbar sind.

2. Vorrichtung nach Anspruch 1, bei der
die Handhabungsvorrichtung (105) eine Verschiebevorrichtung (111) aufweist, welche zum Positionieren der Waferaufnahme (120) relativ zu dem Chassis (110) eingerichtet ist.

3. Vorrichtung nach Anspruch 2, bei der
die Kamera (130) derart angeordnet ist, dass lediglich Bauelemente (122) erfassbar sind, welche sich innerhalb eines Erfassungsbereiches (150) um eine relativ zum Chassis (110) ortsfeste Abholposition befinden.

4. Vorrichtung nach einem der Ansprüche 1 bis 3, bei der
die Kamera (130) mit einer telezentrischen Optik (131) ausgestattet ist.

5. Vorrichtung nach einem der Ansprüche 1 bis 4, zusätzlich mit
• einem ersten Reflektor (233), welcher in dem Strahlengang der Kamera (230) angeordnet ist.

6. Vorrichtung nach einem der Ansprüche 1 bis 5, zusätzlich mit
• einer an dem Chassis (110) der Handhabungsvorrichtung (105) ortsfest angebrachten Beleuchtungseinheit (140), welche derart angeordnet ist, dass die Bauelemente (122) unter einem schrägen Winkel beleuchtbar sind.

7. Vorrichtung nach Anspruch 6, bei der die Bauelemente (122) mit einer Hellfeldbeleuchtung erfassbar sind.

8. Vorrichtung nach einem der Ansprüche 6 bis 7, zusätzlich mit
• einem zweiten Reflektor (148), welcher in dem Strahlengang der Beleuchtungseinheit (140) angeordnet ist.

9. Vorrichtung nach Anspruch 8, bei der
der zweite Reflektor (148) schwenkbar gelagert ist.

10. Vorrichtung nach einem der Ansprüche 1 bis 9, zusätzlich mit
• einer eine der Kamera nachgeschalteten Auswerteeinheit (135) zur Lageerkennung von an der Abholposition befindlichen Bauelementen (122).

11. Verfahren nach Anspruch 10, bei dem
die Auswerteeinheit (135) derart eingerichtet ist, dass eine Verzerrung eines von der Kamera (130) aufgenommenen Bildes kompensierbar ist.
